# EUROPEAN PATENT APPLICATION

(11) **EP 4 669 084 A1**
(43) Date of publication of application: **24.12.2025**
(21) Application number: 24853577.5
(22) Date of filing: 01.08.2024
(51) Int. Cl.: H10K 59/88, H10K 59/131, H10K 59/80

(54) **DISPLAY PANEL AND DISPLAY DEVICE**

(30) Priority: 14.08.2023 CN 202311021581
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: XU, Peng, Beijing 100176 (CN); WANG, Wei, Beijing 100176 (CN); ZHANG, Yi, Beijing 100176 (CN)
(74) Representative: Brötz, Helmut
(86) International application number: PCT/CN2024/109224
(87) International publication number: WO 2025/036165

(57) **Abstract**

Provided are a display panel and a display device. The display panel comprises: a display area, having multiple sub-pixels; and a wiring area, located on one side of the multiple sub-pixels. The wiring area comprises an input area, an output area, and a dummy area; the dummy area is located between the input area and the output area; the input area is provided with multiple input protrusions; the output area is provided with multiple output protrusions; the dummy area is provided with multiple dummy protrusions; a first gap area is present between the multiple output protrusions and the multiple dummy protrusions; a second gap area is present between the multiple input protrusions and the multiple dummy protrusions; and the second gap area is provided with a stress equalization structure. Therefore, the generation of cracks in an inorganic insulating layer in an integrated circuit binding process can be mitigated or avoided, thereby avoiding defects caused by cracks in the inorganic insulating layer.

## Description

The present application claims priority of the Chinese patent application No. 202311021581.2, filed on August 14, 2023, the entire disclosure of which is incorporated herein by reference as part of the present application.

### TECHNICAL FIELD

At least one embodiment of the present disclosure relates to a display panel and a display device.

### BACKGROUND

With the expansion of the application of flexible organic light-emitting diode (OLED) screens, foldable products have gradually occupied the market in recent years.

### SUMMARY

At least one embodiment of the present disclosure provides a display panel and a display device.

In one aspect, at least one embodiment of the present disclosure provides a display panel, including: a display region, provided with a plurality of sub-pixels; and a wiring region, located on a side of the plurality of sub-pixels; the wiring region includes an input region, an output region, and a dummy region, the dummy region is located between the input region and the output region, the input region is provided with a plurality of input bumps, the output region is provided with a plurality of output bumps, the dummy region is provided with a plurality of dummy bumps, a first gap region is provided between the plurality of output bumps and the plurality of dummy bumps, a second gap region is provided between the plurality of input bumps and the plurality of dummy bumps, and a stress equalization structure is arranged in the second gap region.

For example, the stress equalization structure includes a plurality of auxiliary lines, and the plurality of auxiliary lines pass through the second gap region.

For example, the first gap region includes a plurality of signal connection lines, and a wiring density of the plurality of auxiliary lines is greater than or equal to a wiring density of the plurality of signal connection lines.

For example, in a vicinity of the dummy region, orientations of the plurality of signal connection lines are axially symmetrical with orientations of the plurality of auxiliary lines.

For example, the plurality of dummy bumps are arranged in a row along a first direction and are axially symmetrical along a second direction, and in the vicinity of the dummy region, the orientations of the plurality of signal connection lines and the orientations of at least part of the plurality of auxiliary lines are axially symmetrical with respect to the second direction, and the first direction is intersected with the second direction.

For example, each of the plurality of auxiliary lines includes a bent line.

For example, the bent line has a first portion, a second portion, and a third portion, the second portion is located between the first portion and the third portion, an included angle between the second portion and the first portion is an obtuse angle, an included angle between the second portion and the third portion is an obtuse angle, and an orientation of the second portion is from the dummy region to the input region.

For example, the plurality of auxiliary lines include a disconnected line, and the disconnected line is broken at the second portion into two parts located on both sides of the second portion respectively.

For example, the stress equalization structure includes a plurality of auxiliary blocks.

For example, the plurality of auxiliary blocks are arranged in an array.

For example, an area of at least part of the plurality of auxiliary blocks is smaller than an area of each of the plurality of input bumps and smaller than an area of each of the plurality of dummy bumps.

For example, the stress equalization structure includes an auxiliary bump, the auxiliary bump includes a first auxiliary bump, and the first auxiliary bump is located on a side of the plurality of input bumps close to the dummy region.

For example, a minimum spacing between the first auxiliary bump and the plurality of dummy bumps is a first spacing, and a ratio of an absolute value of a difference between the first spacing and a minimum size of the first gap region to the minimum size of the first gap region is greater than or equal to 0 and less than or equal to 10%.

For example, the display panel further includes an alignment mark, the alignment mark is located between the first auxiliary bump and the plurality of input bumps, and a spacing between the first auxiliary bump and an input bump adjacent thereto is greater than a spacing between two adjacent input bumps.

For example, the auxiliary bump further includes a second auxiliary bump, and the second auxiliary bump is located on a side of the plurality of dummy bumps close to the input region.

For example, a minimum spacing between the first auxiliary bump and the second auxiliary bump is a second spacing, and a minimum size of the first gap region is greater than the second spacing.

For example, the minimum size of the first gap region is greater than 1.5 times of the second spacing.

For example, the minimum size of the first gap region is greater than 2 times of the second spacing.

For example, the display panel further includes a peripheral region, the peripheral region surrounds the display region, and the peripheral region is provided with a crack detection line, and the crack detection line passes through the second gap region.

For example, the display panel further includes a source test line, the source test line is located in the peripheral region and on a side of the crack detection line, and the source test line passes through the second gap region.

For example, the display panel further includes a data line, the data line is configured to provide a data voltage to the sub-pixel, and the plurality of output bumps include an output bump connected to the data line.

For example, the display panel further includes an integrated circuit, a plurality of conductive structures in the integrated circuit are respectively connected to the plurality of input bumps, the plurality of output bumps, and the plurality of dummy bumps on the display panel through an anisotropic adhesive.

For example, the display panel further includes an inorganic insulating layer, the inorganic insulating layer at least includes a portion located in the second gap region, and the stress equalization structure is configured to equalize a stress of the portion of the inorganic insulating layer located in the second gap region during an integrated circuit bonding process.

In another aspect, at least one embodiment of the present disclosure further provides a display panel, including: a display region, provided with a plurality of sub-pixels; and a wiring region, located on a side of the plurality of sub-pixels; the wiring region includes an input region, an output region, and a dummy region, the dummy region is located between the input region and the output region, the input region is provided with a plurality of input bumps, the output region is provided with a plurality of output bumps, the dummy region is provided with a plurality of dummy bumps, a first gap region is provided between the plurality of output bumps and the plurality of dummy bumps, a second gap region is provided between the plurality of input bumps and the plurality of dummy bumps, and in the second gap region, a plurality of auxiliary lines, a plurality of auxiliary blocks, or at least one auxiliary bump is provided.

For example, in the display panel provided by the embodiment of the present disclosure, the plurality of auxiliary lines pass through the second gap region, the first gap region includes a plurality of signal connection lines, and a wiring density of the plurality of auxiliary lines is greater than or equal to a wiring density of the plurality of signal connection lines.

For example, in the display panel provided by the embodiment of the present disclosure, an area of each of the plurality of auxiliary blocks is smaller than an area of each of the plurality of input bumps and smaller than an area of each of the plurality of dummy bumps.

For example, in the display panel provided by the embodiment of the present disclosure, the at least one auxiliary bump includes a first auxiliary bump located in the input region and/or a second auxiliary bump located in the dummy region, a ratio of an absolute value of a difference between a minimum spacing between the first auxiliary bump and a dummy bump nearest thereto, a minimum spacing between the second auxiliary bump and an input bump nearest thereto, or a minimum spacing between the first auxiliary bump and the second auxiliary bump, and a minimum size of the first gap region to the minimum size of the first gap region is greater than or equal to 0 and less than or equal to 10%.

In another aspect, at least one embodiment of the present disclosure further provides a display device, including any one of the display panels as mentioned above.

### BRIEF DESCRIPTION OF DRAWINGS

In order to more clearly illustrate the technical solution of the embodiments of the present disclosure, the drawings of the embodiments will be briefly described in the following. It is obvious that the described drawings below are only related to some embodiments of the present disclosure without constituting any limitation thereto.
Fig. 1 is a partial view of a display panel.
Fig. 2 is a schematic diagram of a crack in the display panel shown in Fig. 1.
Fig. 3 is a schematic diagram of a wiring region of a display panel.
Fig. 4 is a schematic diagram of a display panel (before IC bonding) provided by an embodiment of the present disclosure.
Fig. 5 is a schematic diagram of a display panel (after IC bonding) provided by an embodiment of the present disclosure.
Fig. 6 is a schematic diagram of a wiring region of a display panel provided by an embodiment of the present disclosure.
Fig. 7A is a schematic diagram of a wiring region of another display panel provided by an embodiment of the present disclosure.
Fig. 7B is a schematic diagram of a wiring region of another display panel provided by an embodiment of the present disclosure.
Fig. 8A is a schematic diagram of a wiring region of another display panel provided by an embodiment of the present disclosure.
Fig. 8B is a schematic diagram of a wiring region of another display panel provided by an embodiment of the present disclosure.
Fig. 9 is a partial view of a display panel provided by an embodiment of the present disclosure.
Fig. 10 is a partial view of another display panel provided by an embodiment of the present disclosure.
Fig. 11 is a partial view of another display panel provided by an embodiment of the present disclosure.
Fig. 12 is a schematic diagram of a display panel (after IC bonding) provided by an embodiment of the present disclosure.
Fig. 13 is a schematic diagram of a sub-pixel of a display panel provided by an embodiment of the present disclosure.
Fig. 14A is a schematic diagram of a display panel with an anisotropic adhesive layer formed on a base substrate on which bumps are formed before a bonding process.
Fig. 14B is a schematic diagram of a display panel formed after a bonding process.
Fig. 15 is a structural diagram of an integrated circuit.
Fig. 16 is a partial view of a display panel before a bonding process.
Fig. 17 is a partial view of a display panel after a bonding process.

### DETAILED DESCRIPTION

In order to make objectives, technical details and advantages of the embodiments of the present disclosure more clearly, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The words "connection", "connected" and the like are not limited to physical or mechanical connection but may include electrical connection, either directly or indirectly. The words "on", "beneath", "left", "right" and the like only indicate the relative position relationship which is correspondingly changed when the absolute position of a described object is changed.

After flexible OLED is applied to foldable products, the quality of the screen in terms of image quality and avoiding flicker needs to be further improved.

For OLED display products, it can be upgraded from the Low Temperature PolySilicon (LTPS) type to the Low Temperature Polycrystalline-Oxide (LTPO) type to meet the higher image quality requirements of foldable products.

In the LTPO type foldable products, during the manufacturing process, the production line continuously suffers from the defect that 3%-7% of the Panel Crack Detection (PCD) is Not Good (NG). After analysis, cracks occurred in the Integrated Circuit (IC) bonding process, and the cracks cause the panel crack detection line in the IC region to be broken, which in turn causes NG of panel crack detection. Therefore, the problem of NG of panel crack detection is essentially a crack caused by IC bonding.

For a foldable LTPO display panel, NG of panel crack detection caused by the bonding process continues to occur, and obvious cracks can be seen under the microscope. The NG rate of different batches fluctuates between about 3%-7%. The NG of panel crack detection caused by the IC bonding process poses two risks for OLED screens: (1) the panel crack detection has been NG, which will result in that the cracks at other positions of the display panel cannot be detected; (2) The essence of NG of panel crack detection is that cracks occur to the display panel, which may further spread and deteriorate with time or reliability, thus affecting the normal display of the screen. That is, because the display panel has cracks, related defects may be caused by the cracks, and the defects are not limited to NG of panel crack detection.

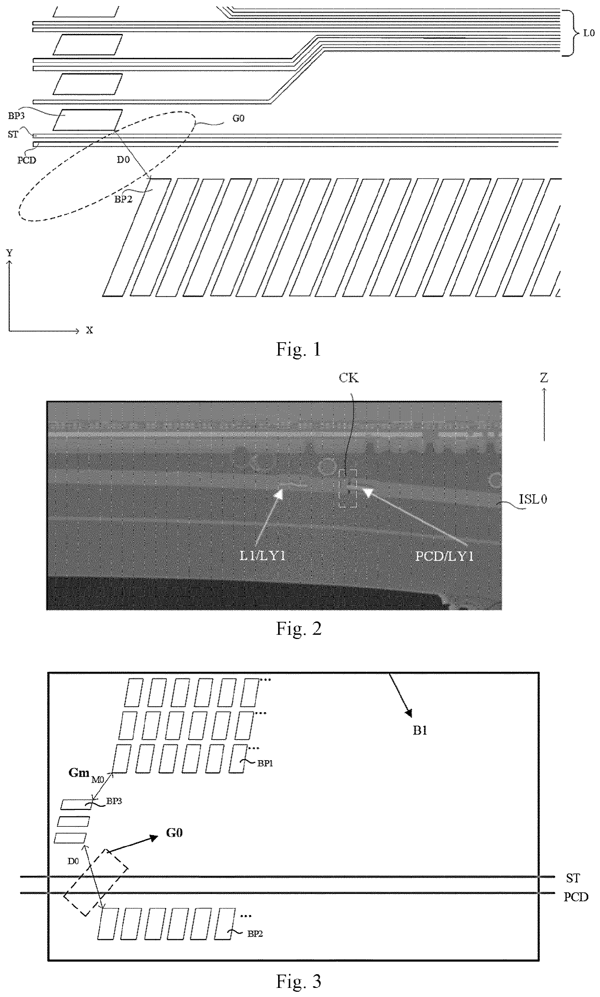

Fig. 1 is a partial view of a display panel. Fig. 2 is a schematic diagram of a crack in the display panel shown in Fig. 1. Fig. 3 is a schematic diagram of a wiring region of a display panel.

As shown in Fig. 1 and Fig. 3, the display panel includes a plurality of input bumps BP2 and a plurality of dummy bumps BP3. Fig. 1 shows a plurality of lines L0. Fig. 3 shows a plurality of output bumps BP1. The black rectangular frame B1 in Fig. 3 is the outer boundary of the IC.

As shown in Fig. 1 and Fig. 3, a gap region G0 is provided between the plurality of input bumps BP2 and the plurality of dummy bumps BP3. As shown in Fig. 3, a gap region Gm is provided between the plurality of output bumps BP1 and the plurality of dummy bumps BP3. The minimum spacing M0 between the plurality of output bumps BP1 and the plurality of dummy bumps BP3 is relatively small.

As shown in Fig. 3, the gap region G0 is relatively large, while the gap region Gm is relatively small. For example, the minimum spacing D0 between the plurality of input bumps BP2 and the plurality of dummy bumps BP3 is relatively large, so that the crack CK occurs to the inorganic insulating layer ISLO at the gap region G0 during the IC bonding process (as shown in Fig. 2).

For example, as shown in Fig. 3, in some embodiments, the minimum spacing M0 is 82 µm, and the minimum spacing D0 is 104µm, which is not limited to this case.

In the embodiments of the present disclosure, the output bumps BP1, the input bumps BP2, and the dummy bumps BP3 may all be called bumps.

As shown in Fig. 1-Fig. 3, the display panel can further include a crack detection line PCD, and the crack CK occurring to the inorganic insulating layer ISLO may cause the crack detection line PCD located on the inorganic insulating layer ISLO to be broken, thus causing NG of panel crack detection.

As shown in Fig. 1, the display panel can further include a source test line ST, and the source test line ST is located between the crack detection line PCD and the plurality of dummy bumps BP3.

Of course, the defects caused by the crack CK occurring to the inorganic insulating layer ISLO are not limited to NG of panel crack detection, and other defects may also be caused; for example, other conductive lines may be caused to be broken, thus causing corresponding defects.

As shown in Fig. 2, the display panel includes a line L1, and the line L1 can be located on the same inorganic insulating layer as the crack detection line PCD. For example, the line L1 and the crack detection line PCD are both located in the same layer, but are not limited thereto. For example, both the line L1 and the crack detection line PCD are located in a first conductive layer LY1, but are not limited thereto. In some other embodiments, the line L1 and the crack detection line PCD can also be located in different layers.

In order to effectively improve the defects caused by cracks in the inorganic insulating layer caused by the IC bonding process, the display panel provided by the embodiments of the present disclosure can be optimized from the following aspects: starting from the region where the cracks occur, auxiliary bumps (which can be regarded as increasing the number of dummy bumps) are added to equalize the stress during bonding under pressure; at the same time, the gap area of the gap region G0 is reduced, so as to reduce the deformation of the display panel and achieve the effect of alleviating or eliminating the cracks caused by the bonding process.

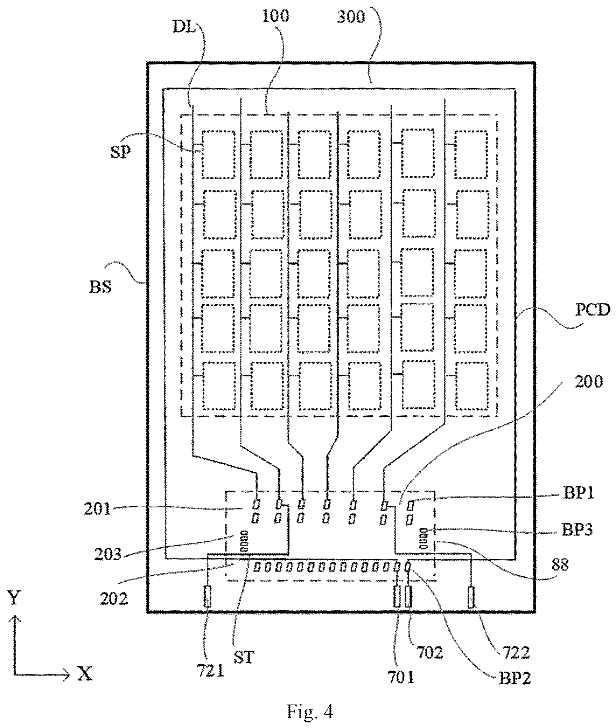

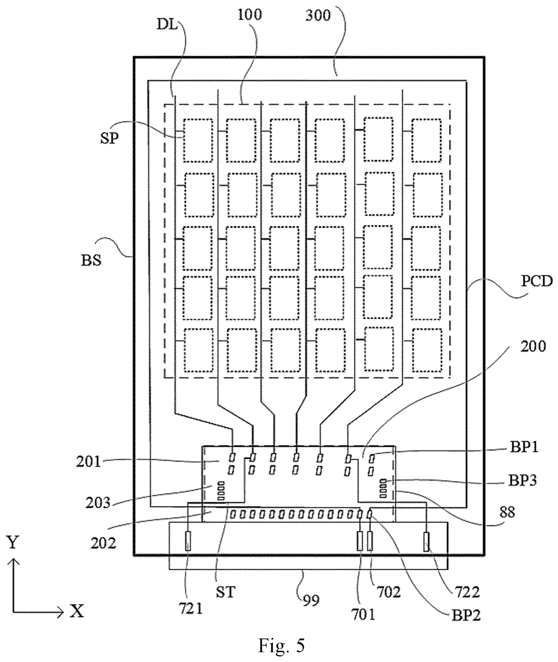

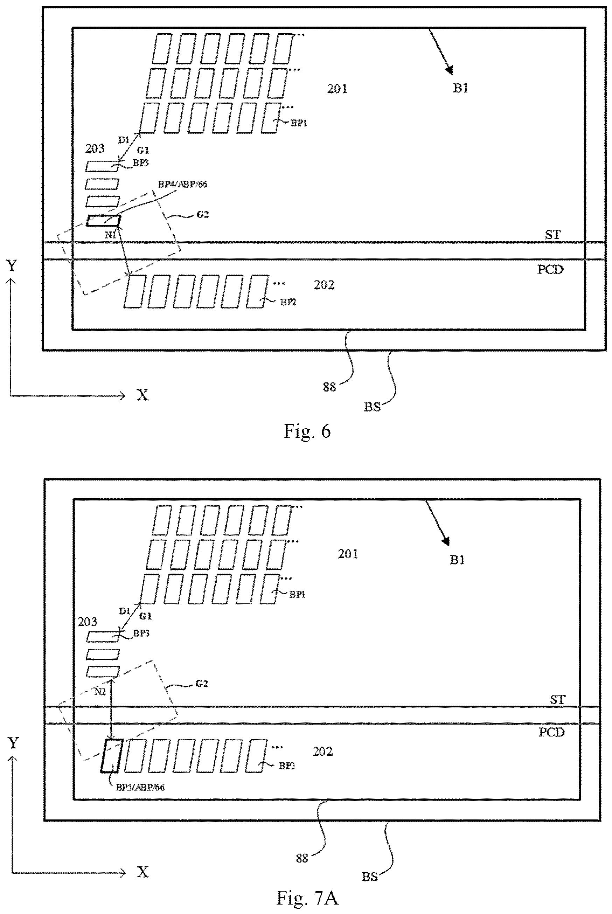

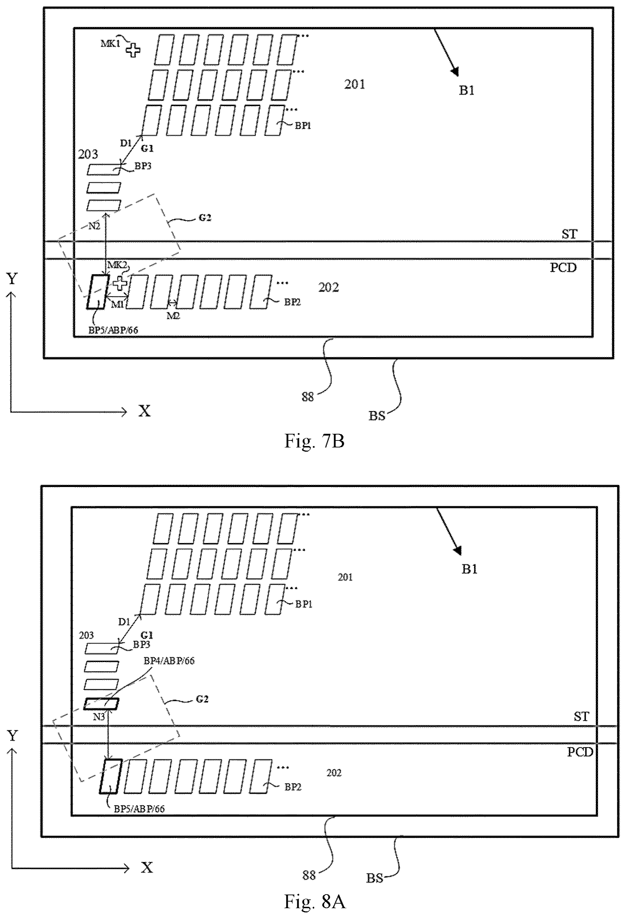

Fig. 4 is a schematic diagram of a display panel (before IC bonding) provided by an embodiment of the present disclosure. Fig. 5 is a schematic diagram of a display panel (after IC bonding) provided by an embodiment of the present disclosure. Fig. 6 is a schematic diagram of a wiring region of a display panel provided by an embodiment of the present disclosure. Fig. 7A is a schematic diagram of a wiring region of another display panel provided by an embodiment of the present disclosure. Fig. 8A is a schematic diagram of a wiring region of another display panel provided by an embodiment of the present disclosure.

As shown in Fig. 4 and Fig. 5, the display panel provided by an embodiment of the present disclosure includes a display region 100 and a wiring region 200. The display region 100 is provided with a plurality of sub-pixels SP. The wiring region 200 is located on a side of the plurality of sub-pixels SP, that is, the wiring region 200 is located on a side of the display region 100. Fig. 4 and Fig. 5 take that the wiring region 200 is located on the left side of the display region 100 as an example.

As shown in Fig. 4 and Fig. 5, the display panel further includes a peripheral region 300, and the peripheral region 300 surrounds the display region 100. The embodiment of the present disclosure takes that the peripheral region 300 surrounds the display region 100 as an example, but it is not limited thereto. The peripheral region 300 can be located on at least a side of the display region 100. For example, the peripheral region 300 can be located on at least one of the left side, the right side, the upper side and the lower side of the display region 100.

As shown in Fig. 4 and Fig. 5, the peripheral region 300 includes the wiring region 200. As shown in Fig. 4 and Fig. 5, the wiring region 200 is a part of the peripheral region 300.

For example, as shown in Fig. 5, the crack detection line PCD is located in the peripheral region 300, and the crack detection line PCD passes through the second gap region G2.

As shown in Fig. 4 and Fig. 5, the wiring region 200 is located in the peripheral region 300. For clarity, Fig. 4 and Fig. 5 do not show all the structures and wires of the display panel.

Fig. 4 and Fig. 5 further show a data line DL. The data line DL is configured to provide a data signal such as a data voltage to the sub-pixel SP. The number of data lines DL is not limited to that shown in Fig. 4 and Fig. 5, but can be determined as needed.

It should be noted that the number of sub-pixels in the display panel is not limited to that shown in Fig. 4 and Fig. 5, and the wires and structures in the display panel are not limited to those shown in Fig. 4 and Fig. 5, but can be determined as needed.

Fig. 5 shows an integrated circuit 88 and a flexible circuit board 99. For example, the integrated circuit 88 and the flexible circuit board 99 can be respectively bonded onto the display panel. For example, the integrated circuit 88 is bonded to conductive structures on the display panel, such as various bumps. For example, the flexible circuit board 99 is bonded to conductive structures on the display panel, such as various bumps. The bumps bonded to the flexible circuit board 99 on the display panel can be connected to the bumps bonded to the integrated circuit 88 on the display panel.

As shown in Fig. 4 and Fig. 5, the crack detection line PCD surrounds the display region 100. Both ends of the crack detection line PCD are respectively connected to the input bumps, and are then connected to the connection structure 701 and the connection structure 702 respectively. As shown in Fig. 5, the connection structure 701 and the connection structure 702 can be connected to conductive structures on the flexible circuit board 99, respectively.

It can be determined whether the crack detection line PCD is broken by detecting the resistance. If the crack detection line PCD is not broken, its resistance is a normal value of a line resistance, and if the crack detection line PCD is broken, its resistance will be very large.

As shown in Fig. 4 and Fig. 5, one end of the source test line ST is connected to a data line DL through an output bump BP1, and the other end of the source test line ST is connected to a connection structure. Fig. 4 and Fig. 5 show two source test lines ST, which are connected to the connection structure 721 and the connection structure 722, respectively. The connection structure 721 and the connection structure 722 can be connected to conductive structures on the flexible circuit board 99, respectively.

The source test line ST is mainly used to test whether the data line DL connected thereto is normal. For example, the waveform on the data line DL connected thereto can be tested through the source test line ST. When display of the display panel is abnormal, a source test can be performed to determine whether the display is abnormal due to the problem of the data line DL.

Fig. 4 and Fig. 5 do not show the conductive structures on the flexible circuit board 99. The conductive structures on the flexible circuit board 99 can be regarded as corresponding to the connection structures on the display panel. For example, the positions of the conductive structures on the flexible circuit board 99 correspond to the positions of the connection structures on the display panel, and the sizes of the conductive structures on the flexible circuit board 99 are substantially the same as the sizes of the connection structures on the display panel, which are not limited thereto.

For example, as shown in Fig. 6-Fig. 8B, the display panel further includes a source test line ST, the source test line ST is located in the peripheral region 300 and on a side of the crack detection line PCD, and the source test line ST passes through the second gap region G2. The source test line ST is configured to test the data line DL. For example, the source test line ST is connected to one of the plurality of data lines DL. The crack detection line PCD is configured to detect a crack in the display panel.

The embodiments of the present disclosure take that the display panel includes a source test line ST and a crack detection line PCD as an example, but it is certainly not limited thereto. The embodiments of the present disclosure may not include at least one of the source test line ST or the crack detection line PCD.

As shown in Fig. 4- Fig. 8B, the wiring region 200 includes an input region 202, an output region 201, and a dummy region 203, and the dummy region 203 is located between the input region 202 and the output region 201.

As shown in Fig. 4- Fig. 8B, the input region 202 is provided with a plurality of input bumps BP2, the output region 201 is provided with a plurality of output bumps BP1, and the dummy region 203 is provided with a plurality of dummy bumps BP3. In the embodiments of the present disclosure, the division of the output region 201, the input region 202, and the dummy region 203 can be based on the connection line of the outermost edges of the bumps located therein.

As shown in Fig. 6-Fig. 8B, a first gap region G1 is provided between the plurality of output bumps BP1 and the plurality of dummy bumps BP3, a second gap region G2 is provided between the plurality of input bumps BP2 and the plurality of dummy bumps BP3, a stress equalization structure 66 is provided in the second gap region G2, and the stress equalization structure 66 is configured to equalize the stress during the integrated circuit bonding process. Therefore, the occurrence of cracks in the inorganic insulating layer can be reduced or avoided during the integrated circuit bonding process, and further, defects caused by cracks in the inorganic insulating layer can be avoided. For example, the breaking of the panel crack detection line caused by cracks in the inorganic insulating layer can be prevented, and NG of panel crack detection can be avoided.

For example, the inorganic insulating layer at least includes a portion located in the second gap region G2, and the stress equalization structure 66 is configured to equalize the stress of the portion of the inorganic insulating layer located in the second gap region G2 during the integrated circuit bonding process.

For example, as shown in Fig. 6, in the display panel provided by the embodiment of the present disclosure, the stress equalization structure 66 includes an auxiliary bump ABP, the auxiliary bump ABP includes an auxiliary bump BP4, and the auxiliary bump BP4 is located on a side of the plurality of dummy bumps BP3 close to the input region 202, so as to reduce the size of the second gap region G2. Fig. 6 shows one auxiliary bump BP4, but the number of auxiliary bumps BP4 is not limited to that shown in the figure, and can be determined as needed. The arrangement of the auxiliary bump BP4 reduces the size of the gap at the second gap region G2, so that the stress is more uniform in this region, the deformation of the portion of the inorganic insulating layer between bumps is smaller, and the occurrence of cracks can be avoided. Theoretically, the smaller the size of the gap, the better. In an extreme case, the size of the gap is similar to the spacing between adjacent bumps. The spacing between adjacent bumps can be the spacing between adjacent dummy bumps or the spacing between a dummy bump and an auxiliary bump that are adjacent to each other.

For example, as shown in Fig. 6, in the display panel provided by the embodiment of the present disclosure, the minimum spacing between the auxiliary bump BP4 and the plurality of input bumps BP2 is a spacing N1. The closer the spacing N1 is to the minimum size D1, or the smaller the spacing N1 is within acceptance of process, the more favorable it is to reduce or remove the cracks of the inorganic insulating layer in the second gap region.

For example, the spacing N1 and the minimum size D1 can be equal or similar.

For example, the ratio R1 of the absolute value of the difference between the spacing N1 and the minimum size D1 of the first gap region G1 to the minimum size D1 is greater than or equal to 0 and less than or equal to 10%. Further, for example, the ratio R1 is greater than or equal to 0 and less than or equal to 5%. Further, for example, the ratio R1 is greater than or equal to 0 and less than or equal to 3%.

For example, the spacing N1 and the minimum size D1 of the first gap region G1 are equal. In this case, the ratio of the absolute value of the difference between the spacing N1 and the minimum size D1 of the first gap region G1 to the minimum size D1 is equal to 0.

For example, as shown in Fig. 6, the spacing N1 is 82 µm, and the minimum size D1 is 82 µm, but it is not limited thereto. For example, in this case, referring to Fig. 3 and Fig. 6, the minimum spacing between the dummy bump BP3 and the input bump BP2 that are adjacent to each other is 104 µm. That is, at the lower left of the display panel, the spacing between bumps can be reduced from 104 µm to 82 µm.

For example, the spacing N1 is 80 µm, and the minimum size D1 is 82 µm. In this case, the ratio R1 is 2.4%.

For example, the spacing N1 is 78 µm, and the minimum size D1 is 82 µm. In this case, the ratio R1 is 4.8%.

For example, as shown in Fig. 6, one or more auxiliary bumps ABP are arranged at a side of the dummy bumps BP3 close to the input region 202 with equal size and equal spacing, so as to reduce the size of the gap at the second gap region G2; therefore, the stress in this region is more uniform during the IC bonding process, the deformation of the portion of the inorganic insulating layer between bumps is reduced, and the occurrence of cracks in the inorganic insulating layer are reduced or avoided, thereby avoiding defects caused by the cracks. Of course, the one or more auxiliary bumps ABP may not be arranged with equal size and equal spacing.

For example, the spacing N1 is less than the minimum size of the second gap region G2. For example, the ratio Ra of the spacing N1 to the minimum size of the second gap region G2 is greater than or equal to 60% and less than or equal to 85%. Further, for example, the ratio Ra is greater than or equal to 70% and less than or equal to 80%. Further, for example, the ratio Ra is about 77%.

In the embodiment of the present disclosure, the minimum size of the second gap region G2 is the spacing between the input bump BP2 and the output bump BP1 that are adjacent to each other, and the minimum spacing D0 marked in Fig. 3 can be referred to.

For example, as shown in Fig. 7A, in the display panel provided by the embodiment of the present disclosure, the stress equalization structure 66 includes an auxiliary bump ABP, the auxiliary bump ABP includes an auxiliary bump BP5, and the auxiliary bump BP5 is located on a side of the plurality of input bumps BP2 close to the dummy region 203. The arrangement of the auxiliary bump BP5 can reduce the size of the gap at the second gap region G2, so as to equalize the stress, eliminate or reduce the cracks in the inorganic insulating layer at this position, and reduce or eliminate the related defects. For details, the previous description can be referred to, which will not be repeated here.

For example, as shown in Fig. 7A, in the display panel provided by the embodiment of the present disclosure, the minimum spacing between the auxiliary bump BP5 and the plurality of dummy bumps BP3 is a spacing N2. In a manner of speaking, the minimum spacing between the auxiliary bump BP5 and the dummy bump BP3 adjacent thereto is a spacing N2. The closer the spacing N2 is to the minimum size D1, or the smaller the spacing N2 is within acceptance of process, the more favorable it is to reduce or remove the cracks in the inorganic insulating layer in the second gap region.

For example, the spacing N2 and the minimum size D1 can be equal or similar.

For example, the ratio R2 of the absolute value of the difference between the spacing N2 and the minimum size D1 of the first gap region G1 to the minimum size D1 is greater than or equal to 0 and less than or equal to 10%. Further, for example, the ratio R2 is greater than or equal to 0 and less than or equal to 5%. Further, for example, the ratio R2 is greater than or equal to 0 and less than or equal to 3%.

For example, the spacing N2 and the minimum size D1 of the first gap region G1 are equal. In this case, the ratio R2 is equal to 0.

For example, the absolute value of the difference between the spacing N2 and the minimum size D1 of the first gap region G1 is greater than or equal to 0 and less than or equal to 2 µm.

For example, as shown in Fig. 7A, the spacing N2 is 84 µm, and the minimum size D1 is 82 µm; in this case, the ratio R2 is equal to 2.4%. In this case, referring to Fig. 3 and Fig. 7A, the minimum spacing between the dummy bump BP3 and the input bump BP2 that are adjacent to each other is 104 µm. That is, at the lower left of the display panel, the spacing between bumps can be reduced from 104 µm to 82 µm.

For example, the spacing N2 is 80 µm, and the minimum size D1 is 82 µm. In this case, the ratio R2 is equal to 2.4%.

For example, the spacing N2 is less than the minimum size of the second gap region G2. For example, the ratio Rb of the spacing N2 to the minimum size of the second gap region G2 is greater than or equal to 60% and less than or equal to 85%. Further, for example, the ratio Rb is greater than or equal to 70% and less than or equal to 85%. Further, for example, the ratio Rb is about 81%.

For example, as shown in Fig. 8A, in the display panel provided by the embodiment of the present disclosure, the stress equalization structure 66 includes an auxiliary bump ABP, the auxiliary bump ABP includes an auxiliary bump BP4 and an auxiliary bump BP5, the auxiliary bump BP4 is located on a side of the plurality of dummy bumps BP3 close to the input region 202, and the auxiliary bump BP5 is located on a side of the plurality of input bumps BP2 close to the dummy region 203. The arrangement of the auxiliary bump BP4 and the auxiliary bump BP5 can reduce the size of the gap at the second gap region G2, so as to equalize the stress, eliminate or reduce the cracks in the inorganic insulating layer at this position, and reduce or eliminate the related defects. For details, the previous description can be referred to, which will not be repeated here.

For example, as shown in Fig. 8A, in the display panel provided by the embodiment of the present disclosure, the minimum spacing between the auxiliary bump BP4 and the auxiliary bump BP5 is the spacing N3, and the minimum size D1 of the first gap region G1 is greater than the spacing N3.

For example, in the display panel provided by the embodiment of the present disclosure, the minimum size D1 of the first gap region G1 is greater than 1.5 times of the spacing N3.

For example, in the display panel provided by the embodiment of the present disclosure, the minimum size D1 of the first gap region G1 is greater than 2 times of the spacing N3.

For example, the spacing N3 is 40 µm, and the minimum size D1 is 82 µm; in this case, the minimum size D1 of the first gap region G1 is greater than two times of the spacing N3. In this case, referring to Fig. 3 and Fig. 8A, the minimum spacing between the dummy bump BP3 and the input bump BP2 that are adjacent to each other is 104 µm. That is, at the lower left of the display panel, the spacing between bumps can be reduced from 104 µm to 40 µm.

For example, in the display panel provided by the embodiment of the present disclosure, the minimum size of the second gap region G2 is greater than 2 times of the spacing N3.

For example, in the display panel provided by the embodiment of the present disclosure, the minimum size of the second gap region G2 is greater than 2.5 times of the spacing N3.

For example, the spacing N3 is less than the minimum size of the second gap region G2. For example, the ratio Rc of the spacing N3 to the minimum size of the second gap region G2 is greater than 20% and less than or equal to 50%. Further, for example, the ratio Rc is greater than or equal to 30% and less than or equal to 40%. Further, for example, the ratio Rc is about 39%.

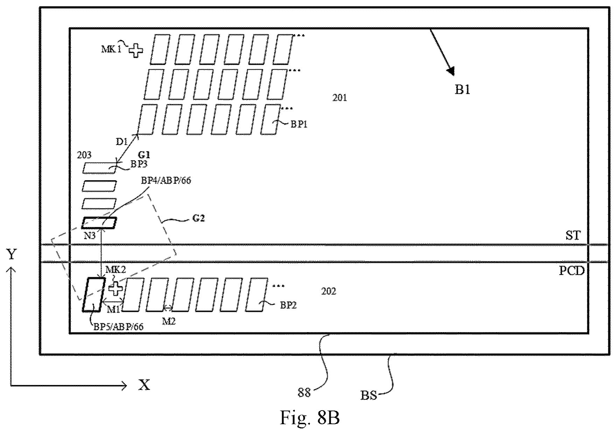

As shown in Fig. 7B and Fig. 8B, the display panel further includes an alignment mark MK2, the alignment mark MK2 is located between the auxiliary bump BP5 and the plurality of input bumps BP2, and the spacing M1 between the auxiliary bump BP5 and the input bump BP2 adjacent thereto is greater than the spacing M2 between two adjacent input bumps BP2. Because the input bump BP2 can be formed by stacking multiple film layers, the alignment mark MK2 is used for alignment when different layer stacks are formed. The alignment mark MK2 can be formed using a film layer of the input bump BP2 closest to the base substrate, such as the first conductive layer LY1, but not limited thereto.

As shown in Fig. 7B and Fig. 8B, the display panel further includes an alignment mark MK1, the alignment mark MK1 is located on a side of the plurality of output bumps BP1. Because the output bump BP1 can be formed by stacking multiple film layers, the alignment mark MK1 is used for alignment when different layer stacks are formed. The alignment mark MK1 can be formed using a film layer of the output bump BP1 closest to the base substrate, such as the first conductive layer LY1, but not limited thereto.

In the case where the layer stack structures of the output bump BP1 and the input bump BP2 are the same, the alignment mark MK1 and the alignment mark MK2 can be used for joint alignment.

Fig. 6-Fig. 8B roughly show the second gap region G2 with a dashed box. Of course, the actual second gap region G2 is not limited to a rectangular shape.

Each of the display panels shown in Fig. 7B and Fig. 8B is provided with an alignment mark MK2, and the relevant size of the second gap region G2 can refer to that in the display panels shown in Fig. 7B and Fig. 8B without the alignment mark MK2, and details will not be repeated here.

In other embodiments, an alignment mark MK1 and an alignment mark MK2 can also be provided to play the role of aligning and marking. For example, the alignment mark MK1 is disposed on a side of the plurality of output bumps BP1, and the alignment mark MK2 is disposed on a side of the plurality of input bumps BP2. Fig. 7B and Fig. 8B are both illustrated with the example that the alignment mark MK1 is disposed on the left side of the plurality of output bumps BP1 and the alignment mark MK2 is disposed on the left side of the plurality of input bumps BP2. In other embodiments, the alignment mark MK1 may also be disposed on the right side of the plurality of output bumps BP1, or alignment marks MK1 may be disposed on both the left side and the right side of the plurality of output bumps BP1. In other embodiments, the alignment mark MK2 is disposed on the right side of the plurality of input bumps BP2, or alignment marks MK2 are disposed on both the left side and the right side of the plurality of input bumps BP2.

Fig. 6-Fig. 8B show three dummy bumps BP3, but the number of dummy bumps BP3 is not limited to that shown in the figures, and can be determined as needed.

Fig. 6-Fig. 8B show a base substrate BS. The plurality of output bumps BP1, the plurality of input bumps BP2, the plurality of dummy bumps BP3, and the stress equalization structure 66 are all disposed on the base substrate BS. The integrated circuit 88 is bonded onto the base substrate BS through a bonding process. The integrated circuit 88 is provided with conductive structures to be bonded to the bumps in the wiring region 200. The form of the conductive structure in the integrated circuit 88 can refer to the form of the bump in the wiring region 200. For example, the arrangement manner of conductive structures in the integrated circuit 88 is the same as that of bumps in the wiring region 200, but it is not limited thereto.

The accompanying drawings of some embodiments of the present disclosure show at least one of a direction X, a direction Y, or a direction Z. Both the direction X and the direction Y are directions parallel to the main surface of the base substrate BS, and the direction X is intersected with the direction Y. For example, the embodiments of the present disclosure take that the direction X is perpendicular to the direction Z as an example. For example, the main surface of the base substrate BS is a surface for manufacturing various components thereon.

In the display panel shown in Fig. 6-Fig. 8B, auxiliary bumps are added, that is, the number and density of dummy patterns are increased, the bonding pressure is equalized, and the area of the gap in the second gap region is reduced, thereby reducing the deformation of the display panel and achieving the effect of eliminating or reducing cracks caused by bonding.

In order to effectively improve the defects caused by cracks in the inorganic insulating layer caused by the IC bonding process, the display panel provided by the embodiments of the present disclosure can be optimized from the following aspects: starting from the pattern density of the region where cracks occur, dummy patterns are added to equalize the stress and deformation amount during bonding, and the dummy patterns are auxiliary blocks.

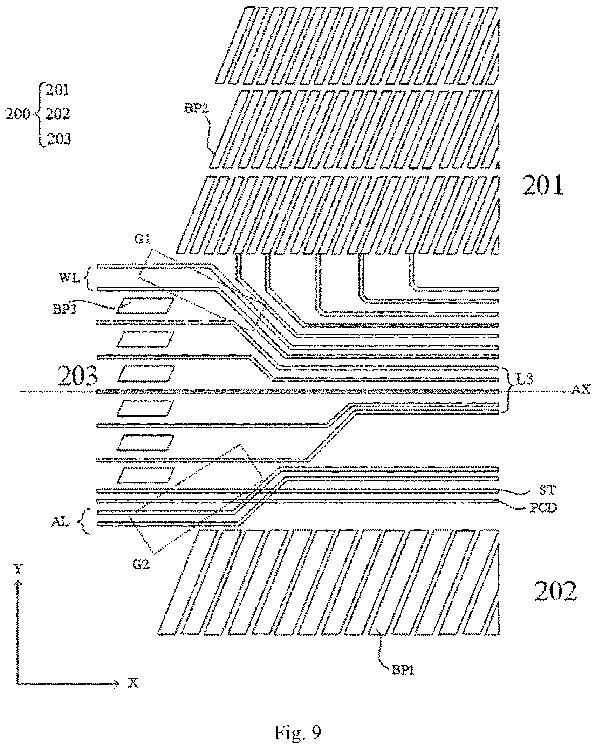

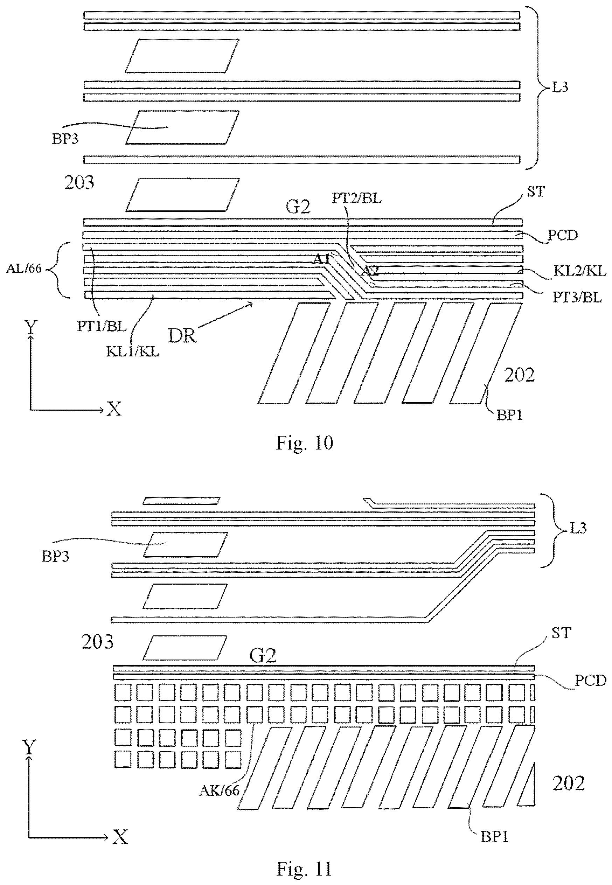

Fig. 9 is a partial view of a display panel provided by an embodiment of the present disclosure. Fig. 10 is a partial view of another display panel provided by an embodiment of the present disclosure. Fig. 11 is a partial view of another display panel provided by an embodiment of the present disclosure.

Fig. 9 shows a first gap region G1 and a second gap region G2 with dashed boxes. As shown in Fig. 9, the minimum size of the first gap region G1 is less than the minimum size of the second gap region G2.

For example, as shown in Fig. 9, in the display panel provided by the embodiment of the present disclosure, the stress equalization structure 66 includes a plurality of auxiliary lines AL, and the plurality of auxiliary lines AL pass through the second gap region G2.

According to the display panel provided by the embodiment of the present disclosure, by arranging a plurality of auxiliary lines AL in the second gap region G2, the occurrence of cracks in the inorganic insulating layer in the second gap region G2 during the integrated circuit bonding process can be avoided or reduced, thereby avoiding various defects caused by the cracks. The plurality of auxiliary lines AL play the role of stress equalization.

For example, as shown in Fig. 9 and Fig. 10, in the display panel provided by the embodiment of the present disclosure, the first gap region G1 includes a plurality of signal connection lines WL, and the wiring density of the plurality of auxiliary lines AL is greater than or equal to the wiring density of the plurality of signal connection lines WL.

For example, as shown in Fig. 9, the signal connection line WL can be a signal line of a Gate Driver on Array (GOA). That is, the signal connection line WL is used to transmit signals and is not a floating line.

As shown in Fig. 9, the plurality of signal connection lines WL include two signal connection lines WL, and the plurality of auxiliary lines AL include four auxiliary lines AL. Of course, the number of the plurality of signal connection lines WL is not limited to that shown in Fig. 9, and the number of the plurality of auxiliary lines AL is not limited to that shown in Fig. 9. Of course, the number of auxiliary lines AL is not limited to that shown in Fig. 10.

For example, as shown in Fig. 9, in the display panel provided by the embodiment of the present disclosure, in the vicinity of the dummy region 203, the orientations of the plurality of signal connection lines WL are symmetrical with the orientations of the plurality of auxiliary lines AL.

As shown in Fig. 9, in the vicinity of the dummy region 203, the orientation of each signal connection line WL among the plurality of signal connection lines WL is along the direction X; and as shown in Fig. 9, the orientation of each auxiliary line AL among the plurality of auxiliary lines AL is along the direction X. In the vicinity of the dummy region 203, the orientations of the plurality of signal connection lines WL are symmetrical with the orientations of the plurality of auxiliary lines AL.

As shown in Fig. 9, at a position relatively far away from the dummy region 203, the orientation of each signal connection line WL among the plurality of signal connection lines WL is towards the lower right; and as shown in Fig. 9, the orientation of each auxiliary line AL among the plurality of auxiliary lines AL is towards the upper right. At the position relatively far away from the dummy region 203, it can be regarded as that the orientations of the plurality of signal connection lines WL are symmetrical with the orientations of the plurality of auxiliary lines AL. In the embodiment of the present disclosure, it is not required that the plurality of signal connection lines WL and the plurality of auxiliary lines AL are completely symmetrically arranged.

For example, as shown in Fig. 9, in the display panel provided by the embodiment of the present disclosure, the plurality of dummy bumps BP3 are arranged in a row along the direction Y and are axially symmetrical along the direction X; and in the vicinity of the dummy region 203, the orientations of the plurality of signal connection lines WL and the orientations of at least part of the auxiliary lines AL are axially symmetrical with respect to the direction X.

For example, as shown in Fig. 9, in the display panel provided by the embodiment of the present disclosure, the plurality of dummy bumps BP3 are arranged in a row, and in the vicinity of the dummy region 203, the orientations of the plurality of signal connection lines WL and the plurality of auxiliary lines AL are symmetrical with respect to an axis AX perpendicular to the arrangement direction of the plurality of dummy bumps BP3. As shown in Fig. 9, the axis AX extends along the direction X.

Fig. 9 further shows a source test line ST and a panel crack detection line PCD. The source test line ST and the panel crack detection line PCD do not belong to the auxiliary lines AL. For example, in a display panel, a source test line ST and a panel crack detection line PCD are usually provided in the second gap region G2. For example, one or more auxiliary lines AL can be provided to facilitate stress equalization of the inorganic insulating layer during the integrated circuit bonding process. Fig. 9 takes providing two auxiliary lines AL as an example. The number of auxiliary lines AL is not limited to that shown in the figure, and can be set as needed. For example, the auxiliary line AL can be a dummy line. The auxiliary line AL can be floating and is not connected to any signal.

For example, as shown in Fig. 9, the source test line ST and the panel crack detection line PCD overlap with the remaining auxiliary lines AL except these two lines. For example, the source test line ST and the panel crack detection line PCD can be located in a different layer from the remaining auxiliary lines AL except these two lines. For example, the source test line ST and the panel crack detection line PCD are located in the first conductive layer, while the remaining auxiliary line AL except these two lines are located in the second conductive layer, but not limited thereto.

For example, as shown in Fig. 10, in the display panel provided by the embodiment of the present disclosure, each of the plurality of auxiliary lines AL includes a bent line BL. The arrangement of the bent line BL can help to avoid crack propagation and prevent cracks from extending into the interior of the display panel.

For example, as shown in Fig. 10, in the display panel provided by the embodiment of the present disclosure, the bent line BL has a first portion PT1, a second portion PT2 and a third portion PT3, the second portion PT2 is located between the first portion PT1 and the third portion PT3, the included angle A1 between the second portion PT2 and the first portion PT1 is an obtuse angle, and the included angle A2 between the second portion PT2 and the third portion PT3 is an obtuse angle. The second portion PT2 can serve as a crack barrier. As shown in Fig. 10, the included angle between the second portion PT2 and the direction X is an obtuse angle, and the included angle between the second portion PT2 and the direction Y is an acute angle. The direction Y can be regarded as a direction pointing from the output region to the input region. The output region is not shown in Fig. 10, and reference can be made to other drawings. As shown in Fig. 10, the orientation of the second portion PT2 is from the dummy region 203 to the input region 202.

As shown in Fig. 10, the extension direction of the second portion PT2 can be perpendicular to a crack propagation direction DR, so as to better prevent crack propagation. The crack propagation direction can refer to the extension direction of the crack. The crack propagation direction DR can be intersected with the direction in which the dummy region 203 points to the input region 202. For example, the included angle between the crack propagation direction DR and the direction in which the dummy region 203 points to the input region 202 is less than or equal to 30 degrees, but it is not limited thereto. The direction in which the dummy region 203 points to the input region 202 can refer to the direction in which the center of the dummy region 203 points to the center of the input region 202. For example, the included angle between the extension direction of the second portion PT2 and the arrangement direction (the direction X) of the plurality of input bumps BP2 is an acute angle, and the included angle between the extension direction of the second portion PT2 and the arrangement direction (the direction Y) of the plurality of dummy bumps BP3 is an obtuse angle. For example, the sum of the acute angle and the obtuse angle is 180 degrees, but it is not limited thereto.

For example, as shown in Fig. 10, in the display panel provided by the embodiment of the present disclosure, the plurality of auxiliary lines AL include a disconnected line KL, and the disconnected line KL is broken at the second portion PT2 into two parts located on both sides of the second portion PT2 respectively. Fig. 10 shows that the disconnected line KL is broken at the second portion PT2 into a first part KL1 and a second part KL2 located on both sides of the second portion PT2 respectively.

For example, as shown in Fig. 10, the bent line BL is located between the crack detection line PCD and the plurality of input bumps 202.

For example, the source test line ST and the bent line BL are respectively arranged on both sides of the crack detection line PCD. As shown in Fig. 10, the source test line ST and the bent line BL are respectively arranged on the upper side and the lower side of the crack detection line PCD.

For example, as shown in Fig. 10, a plurality of bent lines BL are all arranged on the same side of the crack detection line PCD. The plurality of bent lines BL are all arranged on a side of the crack detection line PCD opposite to the side of the crack detection line PCD on which the source test line ST is arranged.

The auxiliary line AL can adopt a stacked structure of at least one of the output bump BP2, the dummy bump BP3, and the input bump BP1. Of course, the auxiliary line AL can also be made of the first conductive layer LY1.

For example, as shown in Fig. 11, in the display panel provided by the embodiment of the present disclosure, the stress equalization structure 66 includes a plurality of auxiliary blocks AK. The plurality of auxiliary blocks AK are arranged in the second gap region G2 to reduce or avoid related defects caused by cracks in the portion of the inorganic insulating layer located in the second gap region G2.

For example, as shown in Fig. 11, in the display panel provided by the embodiment of the present disclosure, the plurality of auxiliary blocks AK are arranged in an array. The plurality of auxiliary blocks AK arranged in an array are helpful to equalize the stress during the integrated circuit bonding process.

For example, as shown in Fig. 11, the area of at least part of the auxiliary blocks AK is smaller than the area of the input bump BP2 and smaller than the area of the dummy bump BP3. For example, as shown in Fig. 11, in the display panel provided by the embodiment of the present disclosure, the area of each of the plurality of auxiliary blocks AK is smaller than the area of each of the plurality of input bumps BP2 and smaller than the area of each of the plurality of dummy bumps BP3. In Fig. 11, the rightmost two auxiliary blocks AK are not completely shown because of the cutting position, and in fact, the areas of the auxiliary blocks AK are the same or basically the same; the rightmost input bump BP1 is not completely shown, and in fact, the areas of the input bumps BP1 are the same or basically the same; the uppermost dummy bump BP3 is not completely shown, and in fact, the areas of the dummy bumps BP3 are the same or basically the same.

Fig. 11 is illustrated by taking that the auxiliary block AK is rectangular, the dummy bump BP3 is strip-shaped, and the input bump BP1 is strip-shaped as an example. However, the shapes of the auxiliary block AK, the dummy bump BP3, and the input bump BP1 are not limited to those shown in the figure.

In the embodiment of the present disclosure, the shapes of various components, such as the output bump BP2, the dummy bump BP3, the input bump BP1, and the auxiliary block AK, can be determined as needed.

For example, the auxiliary block AK can be located in the first conductive layer, and of course, the auxiliary block AK can further optimize the stress by stacking a plurality of conductive layers. For example, the auxiliary block AK can adopt a stacked structure of at least one of the output bump BP2, the dummy bump BP3, and the input bump BP1. Of course, the auxiliary block AK can also be made of the first conductive layer LY1.

For example, in the embodiment of the present disclosure, the auxiliary block AK can be a dummy block, that is, the auxiliary block AK is floating and is not connected to any signal.

Fig. 9- Fig. 11 further show a line L3, which can be a signal line. For example, the line L3 can be a signal line of a Gate Driver on Array (GOA). That is, the line L3 is used to transmit signals and is not a floating line.

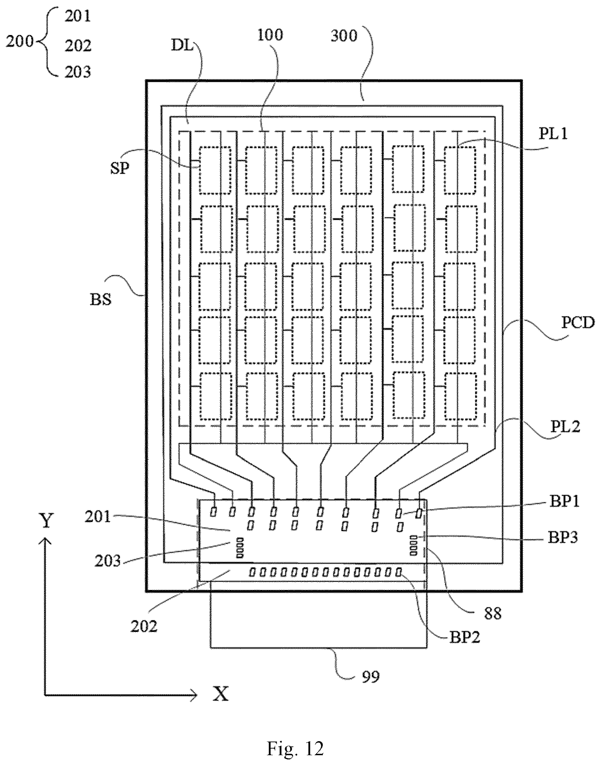

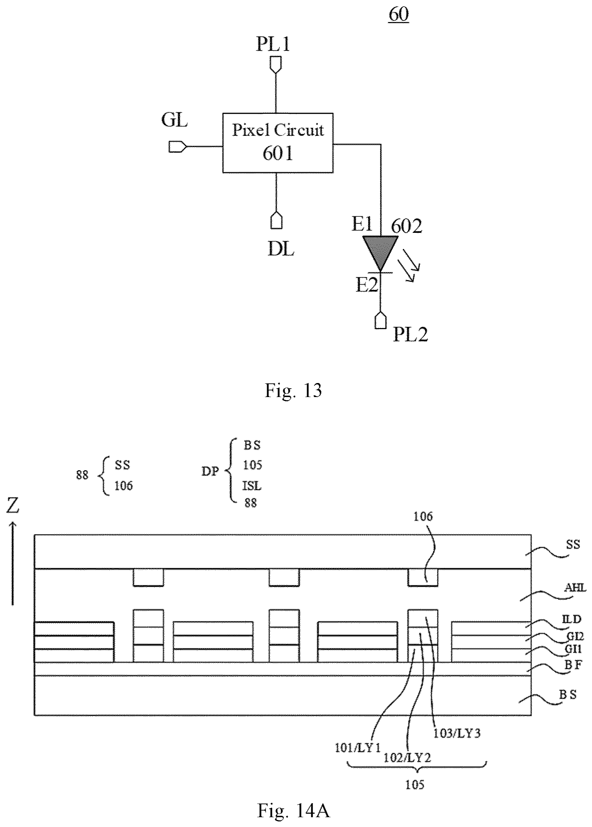

Fig. 12 is a schematic diagram of a display panel (after IC bonding) provided by an embodiment of the present disclosure. Fig. 13 is a schematic diagram of a sub-pixel of a display panel provided by an embodiment of the present disclosure.

As shown in Fig. 12, the display panel includes sub-pixels 60, and the sub-pixels 60 are located on the base substrate BS. As shown in Fig. 13, the sub-pixel 60 includes a pixel circuit 601 and a light-emitting element 602, and the pixel circuit 601 is configured to drive the light-emitting element 602. For example, the pixel circuit 601 is configured to provide a driving current to drive the light-emitting element 602 to emit light. For example, the light-emitting element 602 is an organic light-emitting diode (OLED), but is not limited thereto. The light-emitting element 602 emits red light, green light, blue light, or white light, etc., under the drive of a corresponding pixel circuit 601. The color of light emitted by the light-emitting element 602 can be determined as needed.

For example, as shown in Fig. 12 and Fig. 13, the display panel further includes a data line DL. The data line DL is configured to provide a data voltage Vdt to the sub-pixel SP, and the plurality of output bumps BP1 include an output bump BP1 connected to the data line DL.

For example, as shown in Fig. 12 and Fig. 13, the display panel further includes a data line DL, a first power voltage line PL1, and a second power voltage line PL2. The data line DL is configured to provide a data voltage Vdt to the sub-pixel SP, the first power voltage line PL1 is configured to provide a first power voltage VDD to the sub-pixel SP, the second power voltage line PL2 is configured to provide a second power voltage VSS to the sub-pixel SP, and the plurality of output bumps BP1 include output bumps BP1 respectively connected to the data line DL, the first power voltage line PL1, and the second power voltage line PL2. For example, the first power voltage VDD is greater than the second power voltage VSS.

Fig. 13 further shows a gate line GL. The gate line GL is configured to provide a scan signal to the sub-pixel SP.

Fig. 13 further shows that the light-emitting element 602 includes a first electrode E1 and a second electrode E2. As shown in Fig. 13, the first electrode E1 is connected to the pixel circuit 601, and the second electrode E2 is connected to the second power voltage line PL2. For example, one of the first electrode E1 and the second electrode E2 is an anode, and the other of the first electrode E1 and the second electrode E2 is a cathode.

For example, the pixel circuit 601 includes a transistor and a capacitor. For example, the pixel circuit 601 includes a driving transistor and a data writing transistor.

For example, one of the source electrode and drain electrode of the data writing transistor in the pixel circuit 601 is connected to the data line DL, and the other of the source electrode and drain electrode of the data writing transistor in the pixel circuit 601 is connected to the driving transistor. The gate line GL is connected to the gate electrode of the data writing transistor.

In some embodiments, the pixel circuit 601 includes a driving transistor, a data writing transistor, a light-emitting control transistor, a threshold compensation transistor, a reset control transistor, and a storage capacitor. The structure of the pixel circuit 601 is not limited to the above description, and can be determined as needed.

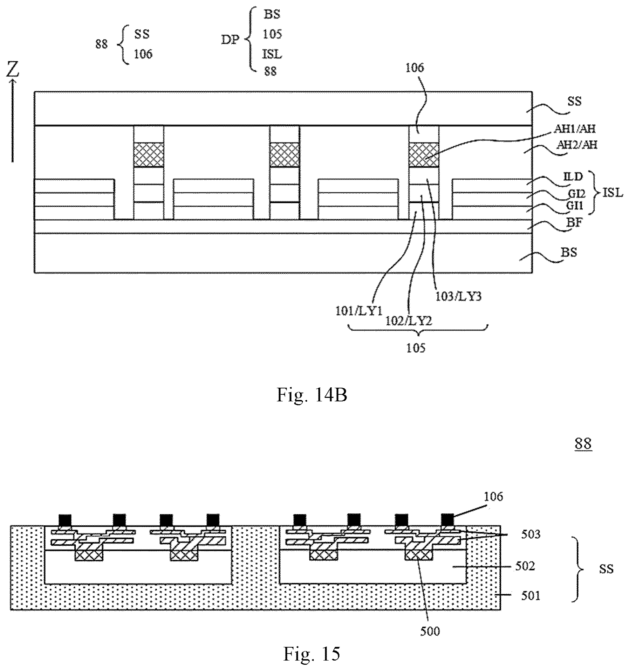

Fig. 14A is a schematic diagram of a display panel with an anisotropic adhesive layer formed on a base substrate on which bumps are formed before a bonding process. Fig. 14B is a schematic diagram of a display panel formed after a bonding process.

As shown in Fig. 14A, an anisotropic adhesive layer AHL is formed on a base substrate with bumps and a plurality of sub-pixels formed thereon.

Fig. 14B shows a base substrate BS and a conductive structure 105 located on the base substrate BS. Fig. 14B further shows an inorganic insulating layer ISL located on the base substrate BS. For example, the inorganic insulating layer ISL includes at least one of a gate insulating layer GI1, a gate insulating layer GI2 and an interlayer insulating layer ILD. For example, the material of the inorganic insulating layer ISL includes an inorganic insulating material. For example, the inorganic insulating material includes at least one of SiOx, SiNy and SiOxNy.

For example, as shown in Fig. 14B, the display panel further includes an integrated circuit 88, and the integrated circuit 88 includes a substrate SS and a plurality of conductive structures 106 located thereon. The plurality of conductive structures 106 can be in one-to-one correspondence with the plurality of conductive structures 105 on the base substrate BS, but it is not limited thereto. The auxiliary bump ABP in the display panel provided by the embodiment of the present disclosure may not correspond to the conductive structure 106 in the integrated circuit 88. That is, in the integrated circuit 88, a conductive structure 106 corresponding to the auxiliary bump ABP is not provided. In other words, the orthographic projection of the plurality of conductive structures 105 on the display panel on the base substrate does not overlap with the orthographic projection of the plurality of conductive structures 106 in the integrated circuit 88 on the base substrate.

As shown in Fig. 14B, the integrated circuit is placed on the base substrate BS, and through a bonding process, under the action of a force, the plurality of conductive structures 106 in the integrated circuit 88 are respectively connected to the plurality of conductive structures 105 on the display panel through anisotropic adhesive AH. For example, the plurality of conductive structures 105 include a plurality of input bumps BP2, a plurality of output bumps BP1, and a plurality of dummy bumps BP3, but are not limited thereto. For example, the plurality of conductive structures 105 can further include at least one auxiliary bump ABP.

Fig. 6-Fig. 8B show an integrated circuit 88 with the substrate SS. The conductive structures 106 in the integrated circuit 88 are not shown in Fig. 6-Fig. 8B. The bumps shown in Fig. 6-Fig. 8B, such as the output bump BP1, the input bump BP2, the dummy bump BP3, and the auxiliary bump ABP, are all structures arranged on the base substrate BS.

For example, the base substrate BS of the display panel includes a flexible base substrate, but is not limited thereto. For example, the flexible base substrate includes polyimide, but is not limited to this, and other suitable flexible substrate materials can also be adopted.

As shown in Fig. 14B, the anisotropic adhesive AH includes a conductive portion AH1 and a non-conductive portion AH2. The conductive structure 106 is connected to the conductive structure 105 through the conductive portion AH1 of the anisotropic adhesive AH.

For example, as shown in Fig. 14B, the conductive structure 105 includes a conductive member 101, a conductive member 102, and a conductive member 103. For example, the conductive member 101 is located in the first conductive layer LY1, the conductive member 102 is located in the second conductive layer LY2, and the conductive member 103 is located in the third conductive layer LY3. For example, at least one of the conductive member 101, the conductive member 102, and the conductive member 103 includes a layer stack structure formed of a plurality of sub-layers. For example, the materials of the conductive member 101, the conductive member 102, and the conductive member 103 include a metal, but are not limited thereto.

For example, as shown in Fig. 14A and Fig. 14B, the first conductive layer LY1 is closer to the base substrate BS than the second conductive layer LY2, and the second conductive layer LY2 is closer to the base substrate BS than the third conductive layer LY3. For example, at the non-bump position, an insulating layer can be arranged between adjacent conductive layers.

For example, the first conductive layer LY1 further includes a gate electrode of a transistor, but it is not limited thereto.

For example, the second conductive layer LY2 further includes a source electrode and a drain electrode of a transistor, but it is not limited thereto.

For example, the third conductive layer LY3 further includes a first power voltage line PL1, but it is not limited thereto.

The crack detection line PCD and the source test line ST in the embodiment of the present disclosure can be made of a conductive material, for example, can be made of a metal material, but not limited thereto.

Fig. 15 is a structural diagram of an integrated circuit. For example, as shown in Fig. 15, the substrate SS of the integrated circuit 88 includes a chip 502 provided with contact pads 500, a re-distribution layer 503 electrically connected to the contact pads 500 on the chip 502, and an encapsulation layer 501 used for protecting the chip 502. The conductive structures 106 are electrically connected to the re-distribution layer 503 to achieve the connection between the chip 502 and other devices. Of course, the substrate SS of the integrated circuit 88 is not limited to the above-mentioned structure, and can be provided as needed.

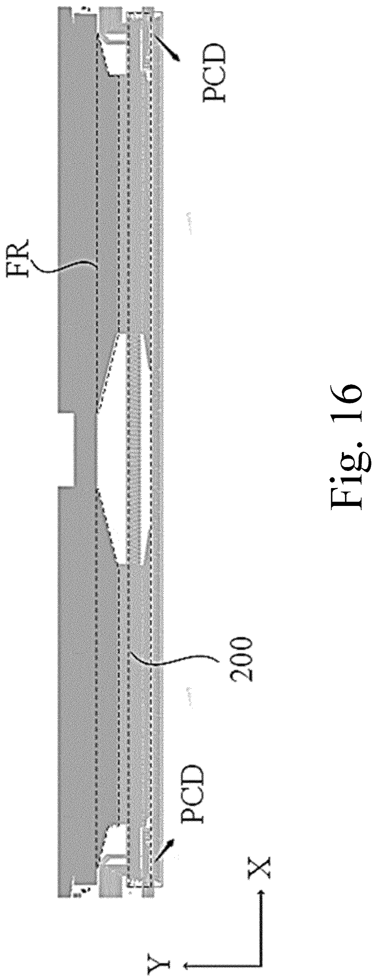

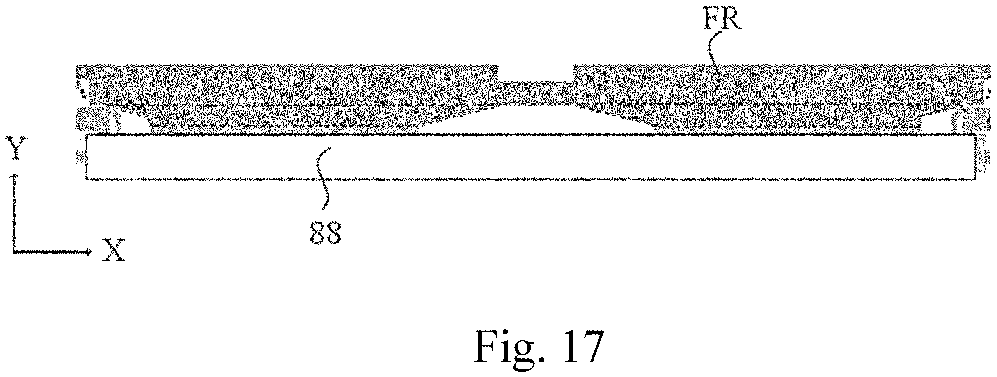

Fig. 16 is a partial view of a display panel before a bonding process. Fig. 17 is a partial view of a display panel after a bonding process. Fig. 16 and Fig. 17 show the arrangement position of the crack detection line PCD and the wiring region 200. Because of the dense lines, the starting position of the arrow in Fig. 16 and Fig. 17 is the arrangement position of the crack detection line PCD, and the crack detection line PCD may not be clearly distinguished. Fig. 16 and Fig. 17 show a fan-out region FR. A plurality of signal lines are fanned out in the fan-out region FR to enter the display region. Fig. 17 shows an integrated circuit 88. Fig. 16 and Fig. 17 show the fan-out region FR with a dashed box, and the wiring region 200 with a dashed box.

For example, in the embodiment of the present disclosure, the bumps located in the same row or in the same column can be arranged with equal size and equal spacing. For example, the input bumps BP2 located in the same row are arranged with equal size and equal spacing. For example, the output bumps BP1 located in the same row are arranged with equal size and equal spacing. For example, the dummy bumps BP3 located in the same column are arranged with equal size and equal spacing. In the case where the auxiliary bump BP5 is provided, the auxiliary bump BP5 can be provided with equal size and equal spacing as the input bumps BP2. In the case where the auxiliary bump BP4 is provided, the auxiliary bump BP4 can be provided with equal size and equal spacing as the dummy bumps BP3.

For example, in the embodiment of the present disclosure, the auxiliary bump BP5 can be referred to as a first auxiliary bump, and the auxiliary bump BP4 can be referred to as a second auxiliary bump.

For example, in the embodiment of the present disclosure, the spacing N2 can be referred to as a first spacing, and the spacing N3 can be referred to as a second spacing.

The various components or structures in the embodiments of the present disclosure can be sorted in the order of occurrence, and it is not necessary to stick to the names with ordered numerals given in the specification.

An embodiment of the present disclosure further provides a display device, which includes any of the above display panels. For example, the display panel can be a foldable display panel, and the display device can be a foldable display device. Of course, the display panel can also be a non-foldable display panel, and the display device can also be a non-foldable display device.

For example, the display device includes an OLED or a product including an OLED. For example, the display device includes any product or component having display function and including the display panel, such as a TV, a digital camera, a mobile phone, a watch, a tablet computer, a laptop computer, a navigator, etc.

It should be noted that, for the purpose of clarity only, in accompanying drawings for illustrating the embodiment(s) of the present disclosure, the thickness and size of a layer or a structure may be enlarged. However, it should be understood that, in the case in which a component or element such as a layer, film, region, substrate or the like is referred to be "on" or "under" another component or element, it may be directly on or under the another component or element or a component or element is interposed therebetween.

The above are only specific embodiments of the present disclosure, but the protection scope of the present disclosure is not limited thereto. Any person skilled in the art can easily conceive of changes or substitutions within the technical scope disclosed in the present disclosure, and these changes or substitutions should be covered within the protection scope of the present disclosure. Therefore, the protection scope of the present disclosure should be subject to the protection scope of the claims.

## Claims

1. A display panel, comprising:
a display region, provided with a plurality of sub-pixels; and
a wiring region, located on a side of the plurality of sub-pixels,
wherein the wiring region comprises an input region, an output region, and a dummy region, the dummy region is located between the input region and the output region,
the input region is provided with a plurality of input bumps, the output region is provided with a plurality of output bumps, the dummy region is provided with a plurality of dummy bumps,
a first gap region is provided between the plurality of output bumps and the plurality of dummy bumps, a second gap region is provided between the plurality of input bumps and the plurality of dummy bumps, and
a stress equalization structure is arranged in the second gap region.

2. The display panel according to claim 1, wherein the stress equalization structure comprises a plurality of auxiliary lines, and the plurality of auxiliary lines pass through the second gap region.

3. The display panel according to claim 2, wherein the first gap region comprises a plurality of signal connection lines, and a wiring density of the plurality of auxiliary lines is greater than or equal to a wiring density of the plurality of signal connection lines.

4. The display panel according to claim 3, wherein in a vicinity of the dummy region, orientations of the plurality of signal connection lines are axially symmetrical with orientations of the plurality of auxiliary lines.

5. The display panel according to claim 4, wherein the plurality of dummy bumps are arranged in a row along a first direction and are axially symmetrical along a second direction, and in the vicinity of the dummy region, the orientations of the plurality of signal connection lines and the orientations of at least part of the plurality of auxiliary lines are axially symmetrical with respect to the second direction, and the first direction is intersected with the second direction.

6. The display panel according to any one of claims 2-5, wherein each of the plurality of auxiliary lines comprises a bent line.

7. The display panel according to claim 6, wherein the bent line has a first portion, a second portion, and a third portion, the second portion is located between the first portion and the third portion, an included angle between the second portion and the first portion is an obtuse angle, an included angle between the second portion and the third portion is an obtuse angle, and an orientation of the second portion is from the dummy region to the input region.

8. The display panel according to claim 7, wherein the plurality of auxiliary lines comprise a disconnected line, and the disconnected line is broken at the second portion into two parts located on both sides of the second portion respectively.

9. The display panel according to claim 1, wherein the stress equalization structure comprises a plurality of auxiliary blocks.

10. The display panel according to claim 9, wherein the plurality of auxiliary blocks are arranged in an array.

11. The display panel according to claim 9 or 10, wherein an area of at least part of the plurality of auxiliary blocks is smaller than an area of each of the plurality of input bumps and smaller than an area of each of the plurality of dummy bumps.

12. The display panel according to claim 1, wherein the stress equalization structure comprises an auxiliary bump, the auxiliary bump comprises a first auxiliary bump, and the first auxiliary bump is located on a side of the plurality of input bumps close to the dummy region.

13. The display panel according to claim 12, wherein a minimum spacing between the first auxiliary bump and the plurality of dummy bumps is a first spacing, and a ratio of an absolute value of a difference between the first spacing and a minimum size of the first gap region to the minimum size of the first gap region is greater than or equal to 0 and less than or equal to 10%.

14. The display panel according to claim 12, further comprising an alignment mark, wherein the alignment mark is located between the first auxiliary bump and the plurality of input bumps, and a spacing between the first auxiliary bump and an input bump adjacent thereto is greater than a spacing between two adjacent input bumps.

15. The display panel according to claim 12, wherein the auxiliary bump further comprises a second auxiliary bump, and the second auxiliary bump is located on a side of the plurality of dummy bumps close to the input region.

16. The display panel according to claim 15, wherein a minimum spacing between the first auxiliary bump and the second auxiliary bump is a second spacing, and a minimum size of the first gap region is greater than the second spacing.

17. The display panel according to claim 16, wherein the minimum size of the first gap region is greater than 1.5 times of the second spacing.

18. The display panel according to claim 16, wherein the minimum size of the first gap region is greater than 2 times of the second spacing.

19. The display panel according to any one of claims 1-18, further comprising a peripheral region, wherein the peripheral region surrounds the display region, and the peripheral region is provided with a crack detection line, wherein the crack detection line passes through the second gap region.

20. The display panel according to claim 19, further comprising a source test line, wherein the source test line is located in the peripheral region and on a side of the crack detection line, and the source test line passes through the second gap region.

21. The display panel according to claim 19, further comprising a data line, wherein the data line is configured to provide a data voltage to the sub-pixel, and the plurality of output bumps comprise an output bump connected to the data line.

22. The display panel according to any one of claims 1-21, further comprising an integrated circuit, wherein a plurality of conductive structures in the integrated circuit are respectively connected to the plurality of input bumps, the plurality of output bumps, and the plurality of dummy bumps on the display panel through an anisotropic adhesive.

23. The display panel according to any one of claims 1-21, further comprising an inorganic insulating layer, wherein the inorganic insulating layer at least comprises a portion located in the second gap region, and the stress equalization structure is configured to equalize a stress of the portion of the inorganic insulating layer located in the second gap region during an integrated circuit bonding process.

24. A display panel, comprising:
a display region, provided with a plurality of sub-pixels; and
a wiring region, located on a side of the plurality of sub-pixels,
wherein the wiring region comprises an input region, an output region, and a dummy region, the dummy region is located between the input region and the output region,
the input region is provided with a plurality of input bumps, the output region is provided with a plurality of output bumps, the dummy region is provided with a plurality of dummy bumps,
a first gap region is provided between the plurality of output bumps and the plurality of dummy bumps, a second gap region is provided between the plurality of input bumps and the plurality of dummy bumps, and
in the second gap region, a plurality of auxiliary lines, a plurality of auxiliary blocks, or at least one auxiliary bump is provided.

25. The display panel according to claim 24, wherein the plurality of auxiliary lines pass through the second gap region, the first gap region comprises a plurality of signal connection lines, and a wiring density of the plurality of auxiliary lines is greater than or equal to a wiring density of the plurality of signal connection lines.

26. The display panel according to claim 24 or 25, wherein an area of each of the plurality of auxiliary blocks is smaller than an area of each of the plurality of input bumps and smaller than an area of each of the plurality of dummy bumps.

27. The display panel according to any one of claims 24-26, wherein the at least one auxiliary bump comprises a first auxiliary bump located in the input region and/or a second auxiliary bump located in the dummy region, a ratio of an absolute value of a difference between a minimum spacing between the first auxiliary bump and a dummy bump nearest thereto, a minimum spacing between the second auxiliary bump and an input bump nearest thereto, or a minimum spacing between the first auxiliary bump and the second auxiliary bump, and a minimum size of the first gap region to the minimum size of the first gap region is greater than or equal to 0 and less than or equal to 10%.

28. A display device, comprising the display panel according to any one of claims 1-27.
